Europäisches Patentamt

European Patent Office

Office européen des brevets

(11) Numéro de publication: **0 196 960**
**A1**

(12) # DEMANDE DE BREVET EUROPEEN

(21) Numéro de dépôt: **86400568.1**

(22) Date de dépôt: **18.03.86**

(51) Int. Cl.⁴: **F 02 D 41/20**
**H 03 K 17/64**

(30) Priorité: **28.03.85 FR 8504690**

(43) Date de publication de la demande:
**08.10.86 Bulletin 86/41**

(84) Etats contractants désignés:
**DE GB IT SE**

(71) Demandeur: **REGIE NATIONALE DES USINES RENAULT**
**Boîte postale 103 8-10 avenue Emile Zola**
**F-92109 Boulogne-Billancourt(FR)**

(72) Inventeur: **Ranc, Denis**
**14, rue Mermoz**
**F-69800 Saint Priest(FR)**

(74) Mandataire: **Réal, Jacques et al,**
**Régie Nationale des Usines Renault SCE 0804**
**F-92109 Boulogne Billancourt Cedex(FR)**

(54) **Dispositif de commande d'organes électromagnétiques à actionnement rapide.**

(57) Le dispositif comporte un condensateur d'accumulation (CP), un inducteur (IND) monté entre la polarité (+) et un point intermédiaire (I), lui-même raccordé à la polarité (−) par un interrupteur électronique de charge (IC), un autocommutateur (TH1; R1, Z) fonctionnant dans le sens permettant à la haute tension produite au point intermédiaire (I) de charger le condensateur (CP), et un générateur de courant constant (GCC) propre à assurer le courant de maintien et monté en parallèle avec l'inducteur (IND) et l'autocommutateur (TH1), ce générateur comportant en série une première diode (D1) empêchant les impulsions à haute tension de charge de remonter vers la source.

FIG.1

EP 0 196 960 A1

Dispositif de commande d'organes électromagnétiques à actionnement rapide.

L'invention concerne les dispositifs électroniques de commande d'organes électromagnétiques à actionnement rapide, tels qu'électro-annes ou injecteurs, assurant dans chacun des organes commandés une forte pointe de courant d'appel, au moment du déclenchement, suivie par un courant de maintien beaucoup plus modéré.

On connaît déjà, d'après le brevet FR-2 495 824, un dispositif de ce genre dans lequel l'accumulation d'énergie a lieu exclusivement dans un bobinage inducteur.

On connaît également d'autres dispositifs, tels celui décrit dans le brevet U.S. 3 665 901, dans lequel l'accumulation de l'énergie nécessaire pour assurer la pointe de courant est effectuée dans un condensateur placé en parallèle avec un inducteur, tandis que le courant de maintien traverse l'inducteur après la décharge du condensateur. Toutefois dans un tel dispositif, du fait que le courant de maintien traverse l'inducteur, lorsque le transistor de commande générale se bloque, cela produit aux bornes du condensateur une inversion de polarité, ce qui nécessite par conséquent l'utilisation d'un condensateur non polarisé de forte capacité, beaucoup plus gros et onéreux que les condensateurs polarisés.

Le but de l'invention est de réaliser un dispositif d'alimentation du type précité, c'est-à-dire avec accumulation d'énergie dans au moins un condensateur, mais dans lequel il n'y ait pas d'inversion de polarité aux bornes du condensateur, afin de permettre notamment l'utilisation de condensateurs polarisés tels que les condensateurs électrolytiques.

En outre, dans l'application à l'injection et dans le cas où l'on pratique l'injection en deux temps, avec une préinjection suivie peu de temps après de l'injection proprement dite, le dispositif doit pouvoir assurer un tel fonctionnement.

L'invention consiste à disposer les organes électromagnétiques commandés en parallèle, avec chacun son interruption électronique de déclenchement placé en série, entre une ligne de retour réunie directement à une polarité et une ligne d'aller alimentée à partir d'un point commun, à disposer un condensateur d'accumulation primaire entre ce point commun et ladite polarité, à produire une haute tension de charge par un inducteur monté entre l'autre polarité et un point intermédiaire lui-même raccordé à la polarité de la ligne de retour par un interrupteur électronique de charge, actionné une ou plusieurs fois à des instants intermédiaires entre les instants d'actionnement des interrupteurs de déclenchement, à disposer entre ce point intermédiaire et le point commun un autocommutateur fonctionnant dans le sens permettant à la haute tension produite de charger le condensateur, et à raccorder, en parallèle avec l'inducteur et l'autocommutateur, entre la polarité correspondante et le point commun, un générateur de courant constant propre à assurer le courant de maintien, suivi d'une première diode empêchant la haute tension de suivre le chemin inverse.

Grâce à cette disposition le courant de maintien ne traverse pas l'inducteur et le condensateur d'accumulation est à polarisation constante, permettant l'utilisation d'un condensateur polarisé.

Pour une commande double, en particulier pour des injecteurs utilisant une préinjection suivie de peu par l'injection proprement dite ne permettant pas dans leur intervalle de recharger le condensateur, le dispositif se complète par une deuxième diode, par l'intermédiaire de laquelle la ligne d'aller est alimentée à partir du point commun, un condensateur d'accumulateur secondaire raccordé entre la ligne de retour et un point de jonction, une troisième diode disposée entre le point commun et ce point de jonction dans le sens assurant la charge du condensateur secondaire en même temps que se produit celle du condensateur principal, et un thyristor ou similaire raccordé entre le point de jonction et la ligne d'aller et commandé en synchronisme avec l'interrupteur individuel de déclenchement de l'organe correspondant lors de l'injection proprement dite, et non lors de la pré-injection.

D'autres particularité de l'invention apparaîtront dans la description qui va suivre de deux variantes de réalisation prises comme exemples et représentées sur le dessin annexé sur lequel :

la figure 1 est le schéma du dispositif de base à commande simple;

la figure 2 est le chronogramme de l'actionnement des divers organes principaux de ce dispositif simple;

la figure 3 correspond à la figure 1 dans la version modifiée de commande double avec préinjection et injection; et

la figure 4 est le chronogramme correspondant à cette version à commande double.

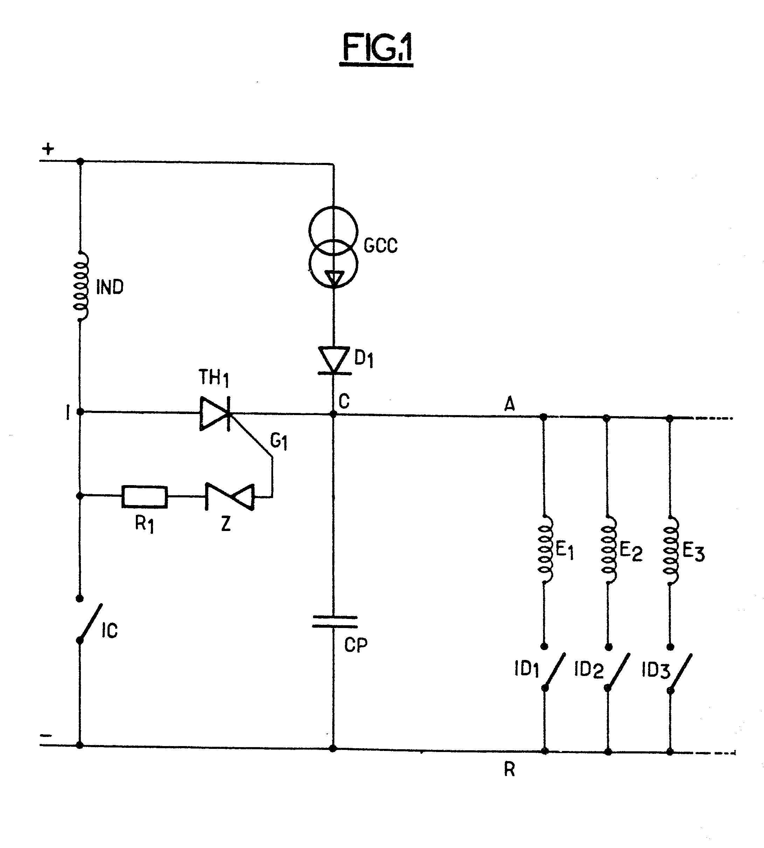

On a représenté sur la figure 1 les divers enroulements E1, E2, E3 des organes à commander, chacun étant placé en série avec son interrupteur de déclenchement individuel ID1, ID2, ID3, les divers montage étant eux-mêmes placés en parallèle entre une ligne d'aller A et une ligne de retour R, cette dernière étant réunie à une polarité, par exemple à la borne (-) ou à la masse.

La ligne d'aller A est alimentée à partir d'un point commun C. Un condensateur primaire d'accumulation d'énergie CP est raccordé entre ce point C et la ligne R, c'est-à-dire la polarité (-).

Pour charger ce condensateur on produit une haute tension à l'aide d'une bobine d'induction IND raccordée entre l'autre polarité (+) et un point intermédiaire I, tandis qu'un interrupteur électronique de charge IC est raccordé entre ce point intermédiaire I et la polarité (-). Lorsque IC se ferme, le courant traverse donc l'inducteur IND, et lorsqu'il s'ouvre, il se produit en I une impulsion à haute tension qui va être utilisée pour charger le condensateur CP. Pour cela on dispose entre I et C d'un autocommutateur constitué par un thyristor TH1 qui se trouve autocommandé, en ce sens que la différence de potentiel apparaissant entre I et C produit directement l'avalanche sans nécessiter d'action sur sa gâchette G1. Cette dernière est toutefois utilisée de préférence pour être raccordée à I par l'intermédiaire d'une résistance R1 et d'une diode Zener Z pour faciliter le déclenchement tout en le retardant légèrement dans un but de sécurité. Par exemple si la diode Zener a une tension caractéristique de 15 volts, lors de la coupure de IC le thyratron TH1 ne déclenche que lorsque la tension en I dépsse de cette valeur de 15 volts la tension en C.

Pour produire la charge du condensateur CP il suffit donc d'actionner l'interrupteur électronique IC, de préférence plusieurs fois, et cela à l'intérieur des intervalles de temps entre deux actionnements des divers interrupteurs de déclenchement individuels ID1, ID2, ID3...

En dehors de ces périodes d'ouverture de l'interrupteur de charge IC et après le passage de l'impulsion de haute tension, c'est-à-dire lorsque le point intermédiaire I a son potentiel qui est retourné à son potentiel de la source (+), le thyratron TH1 ne conduit pas et n'assure donc pas le courant de maintien dans les organes commandés.

Conformément à l'invention, ce courant de maintient est assuré par un générateur de courant constant GCC monté en parallèle avec l'inducteur IND et le thyratron TH1, c'est-à-dire entre la borne (+) et le point commun C, en série avec une diode D1 empêchant le retour inverse de la haute tension de charge.

Grâce à cette disposition, le condensateur primaire CP ne subit jamais d'inversion de polarité, ce qui permet d'assurer au condensateur une grande capacité sous un faible volume et à un faible coût par l'emploi d'un condensateur électrolytique.

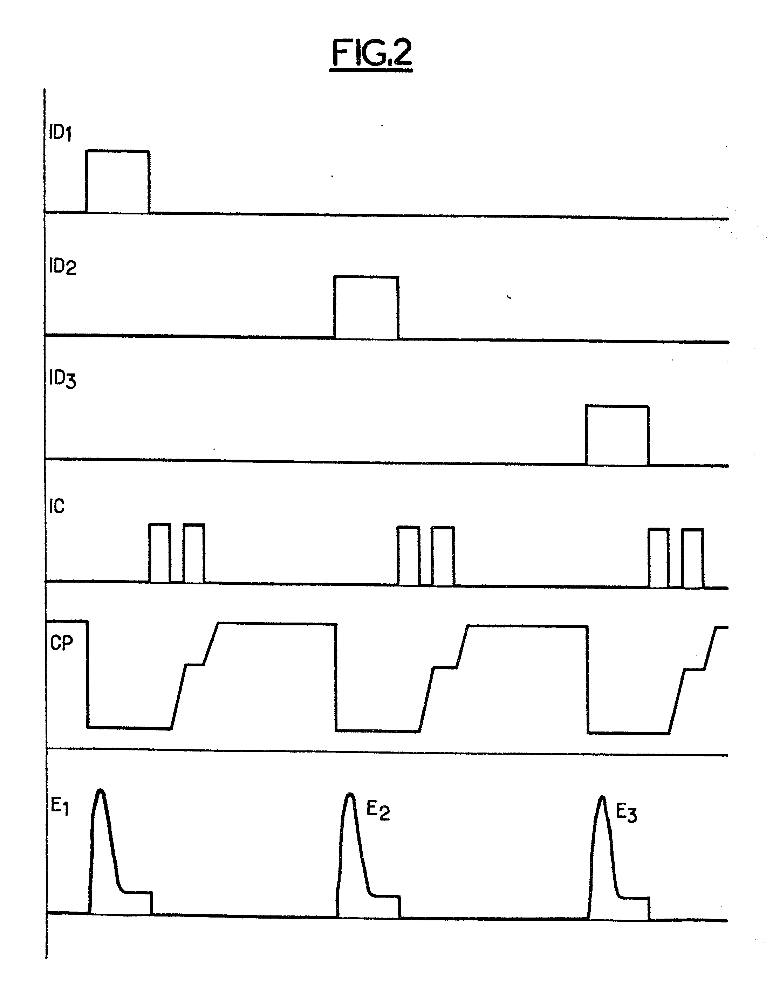

Le chronogramme de la figure 2 permet de suivre en fonction du temps l'imbrication des diverses phases de fonctionnement. Chaque courbe représente en ordonnée une intensité ou une tension de charge repérée par la même référence que l'organe correspondant. On voit en particulier les diverses ondes rectangulaires d'actionnement des divers interrupteurs de déclenchement individuels ID1, ID2, ID3 correspondant aux divers injecteurs. On voit également les impulsions rectangulaires successives, ici par paires, d'actionnement de l'interrupteur de charge IC dans l'intervalle entre les périodes d'injection. La courbe CP montre l'état de charge du condensateur primaire CP, avec ses périodes de décharge et de recharge successives. On voit enfin les intensités de commande dans les divers enroulements E1, E2, E3, ces dernières étant représentées sur le même axe pour plus de commodité. Chacune de ces courbes de commande comprend visiblement une pointe de forte intensité correspondant à l'appel rapide, suivie d'une intensité modérée de maintien, cette dernière qui est celle fournie par GCC.

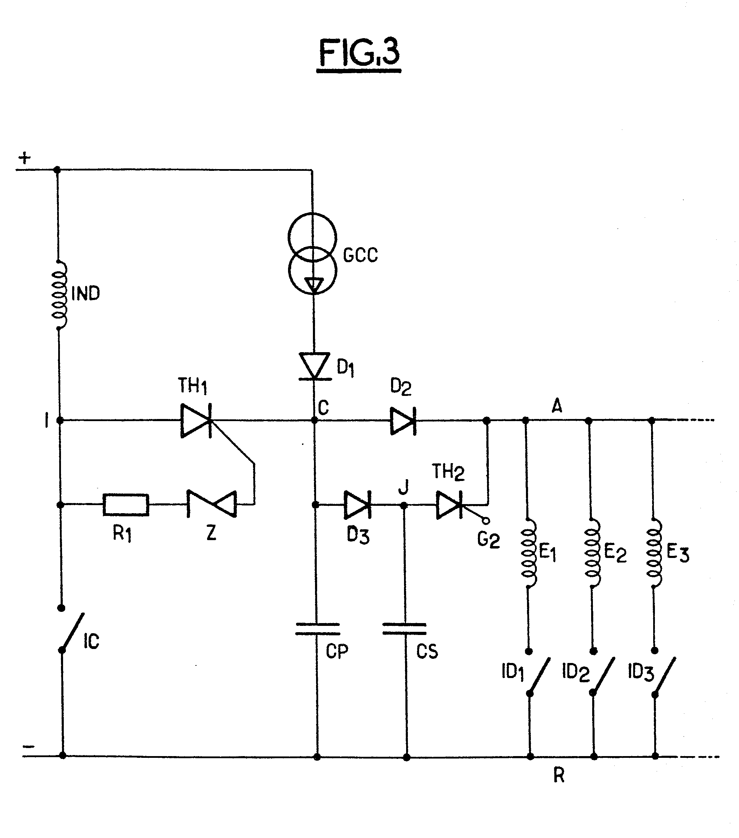

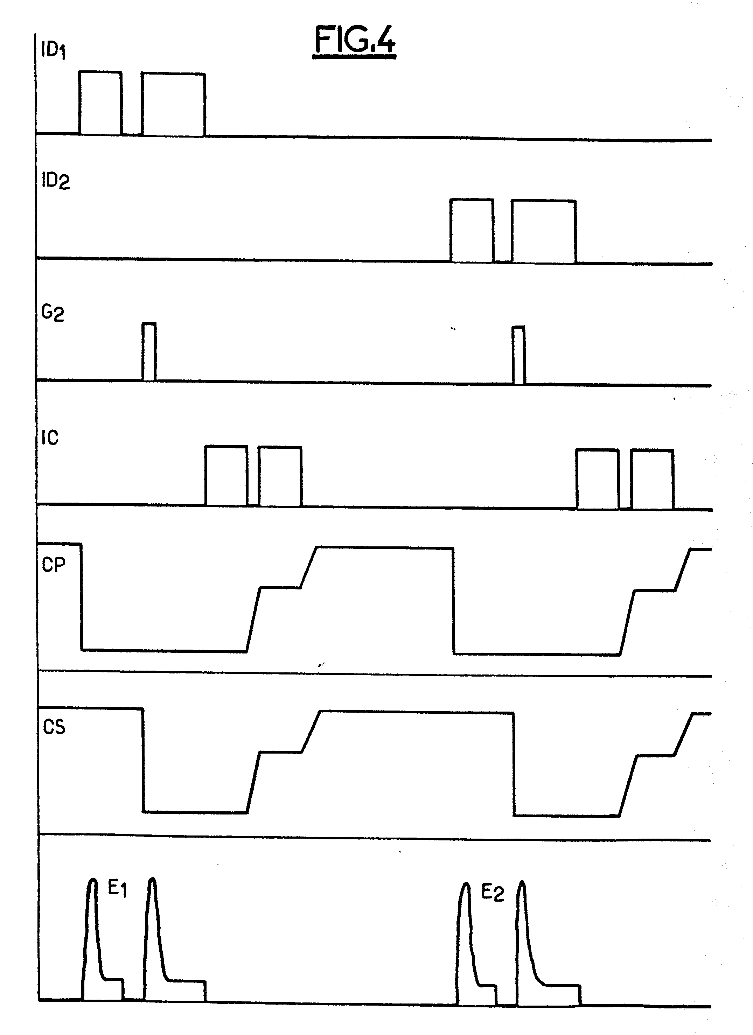

Lorsque les impulsions de commande dans chaque organe commandé se suivent par paires, avec un intervalle insuffisant pour assurer la recharge du condensateur dans cet intervalle, en particulier dans le cas des injecteurs utilisant une préinjection précédant l'injection proprement dite, on peut avantageusement modifier le dispositif selon la variante représentée sur la figure 3. On y retrouve exactement les mêmes éléments, représentés par les mêmes références, à ceci près qu'en plus du condensateur primaire d'accumulation CP est prévu un deuxième condensateur d'accumulation secondaire CS, ce dernier ayant également sa borne négative raccordée à la ligne de retour R et sa borne positive raccordée à un point de jonction J, et que la ligne d'aller A est alimentée toujours à partir du point commun C mais par l'intermédiaire d'une diode D2. Une autre diode D3 est raccordée entre le point commun C et le point de jonction J dans le sens qui permet la charge du condensateur secondaire CS en même temps que se produit celle du condensateur primaire CP de la même manière qu'indiquée précédemment. Enfin entre J et A se trouve un deuxième thyristor TH2 dont la gâchette G2 est actionnée en synchronisme avec chacun des interrupteurs électroniques individuels de déclenchement ID1, ID2, ID3 etc., mais seulement lors du deuxième temps de fonctionnement correspondant à l'injection proprement dite, et non lors de la préinjection, comme cela apparaît clairement sur la troisième ligne de l'organigramme de la figure 4.

Par rapport à la première version, les phases de charge des condensateurs CP et CS se produisent exactement de la même manière. La préinjection se produit également de la même manière qu'indiquée précédemment par simple fermeture des interrupteurs individuels ID1, ID2, ID3, ce qui a pour effet d'utiliser l'énergie accumulée dans la condensateur CP et non celle accumulée dans le condensateur secondaire CS qui demeure isolé entre la diode D3 et le tyristor TH2. Ce n'est qu'au cours d'une troisième phase de fonctionnement, correspondant au deuxième temps d'injection principale, que les interrupteurs de déclenchement ID1, ID2 ou ID3 sont commandés en synchronisme

6     **0196960**

avec la gâchette G2 et que par suite la charge du condensateur secondaire CS peut s'écouler dans la ligne A, la diode D2 empêchant cette charge de repartir vers le condensateur primaire CP.

Comme précédemment, le condensateur secondaire CS tout comme le condensateur principal CP ne subit aucune inversion de polarité et permet par conséquent d'utiliser un condensateur électrolytique.

Naturellement les organes assurant la chronologie des diverses commandes ne sont pas représentés et font partie de l'état de la technique.

REVENDICATIONS

1. Dispositif de commande propre à assurer une forte pointe de courant d'appel suivie d'un courant de maintien modéré pour l'alimentation d'organes électromagnétiques à actionnement rapide, caractérisé par le fait qu'il comporte :

- une ligne de retour (R )réunie directement à une polarité (-) et une ligne d'aller (A) alimentée à partir d'un point commun (C), le ou les organes électromagnétiques (E1, E2, E3) étant montés en parallèle entre cette ligne d'aller (A )et cette ligne de retour (R), avec chacun son interrupteur individuel de déclenchement (ID1, ID2 et ID3) placé en série,

- un condensateur d'accumulation primaire (CP) raccordé entre le point commun (C) et ladite polarité (R, -),

- un inducteur (IND) monté entre l'autre polarité (+) et un point intermédiaire (I), lui-même raccordé à la polarité (-) de la ligne de retour (R) par un interrupteur électronique de charge (IC) actionné un certain nombre de fois à des instants intermédiaires entre les instants d'actionnement des interrupteurs électroniques de déclenchement (ID1, ID2, ID3),

- un autocommutateur (TH1; R1, Z) fonctionnant dans le sens permettant à la haute tension produite au point intermédiaire (I) de charger le condensateur primaire (CP), et

- un générateur de courant constant (GCC) propre à assurer le courant de maintien et monté en parallèle avec l'inducteur (IND) et l'autocommutateur (TH1), ce générateur comportant en série une première diode (D1) empêchant les impulsions à haute tension de charge de remonter vers la source.

2. Dispositif de commande selon la revendication 1, caractérisé par le fait que l'autocommutateur comprend un dispositif à avalanche du type thyristor (TH1) dont la gâchette (G1) est réunie au point intermédiaire (I) par l'intermédiaire d'une diode Zener (Z) et d'une résistance (R1) pour assurer le déclenchement de la conduction dès que le potentiel du point intermédiaire (I) dépasse le potentiel du point commun (C) d'un seuil déterminé.

3. Dispositif de commande selon l'une des revendications précédentes, destiné à produire des impulsions de commande se suivant par paires à un faible intervalle de temps entre les deux impulsions d'une même paire, en particulier pour des injecteurs à préinjection, caractérisé par le fait que

- ladite ligne d'aller (A) est alimentée à partir du point commun (C) par l'intermédiaire d'une diode (D2) de sens correspondant,

- qu'il est prévu un condensateur secondaire (CS) en plus du condensateur primaire (CP), ce condensateur secondaire étant raccordé entre la ligne de retour (R) et un point de jonction (J),

- qu'une troisième diode (D3) est raccordée entre le point commun (C) et le point de jonction (J) dans le sens assurant la charge du condensateur secondaire en même temps que se produit celle du condensateur primaire, et

- un deuxième thyristor (TH2) raccordé entre le point de jonction (J) et la ligne d'aller (A) et dont la gâchette (G2) est commandée en synchronisme avec l'instant de fermeture de chacun des interrupteurs de déclenchement individuels (ID1, ID2, ID3), mais seulement pour le deuxième temps de fonctionnement de chaque paire d'impulsions.

4. Dispositif de commande selon une des revendications précédentes, caractérisé par le fait que le (CP) ou les (CP, CS) condensateurs utilisés sont des condensateurs polarisés, en particulier du type électrolytique.

1/4

0196960

FIG.1

0196960

# FIG.2

0196960

# FIG.3

4/4

FIG.4

Office européen
des brevets

**RAPPORT DE RECHERCHE EUROPEENNE**

0196960
Numéro de la demande

EP 86 40 0568

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl 4) |
|---|---|---|---|
| X | FR-A-2 538 942 (RENAULT) <br> * Page 1, ligne 25 - page 4, ligne 6; page 4, lignes 27-33; page 5, lignes 8-13; figures 1,4 * | 1,2,4 | F 02 D 41/20 <br> H 03 K 17/64 |
| A,D | US-A-3 665 901 (MONPETIT et al.) <br> * Figure 9; colonne 10, ligne 33 - colonne 11, ligne 30; colonne 12, ligne 51 - colonne 13, ligne 4 * | 1-3 | |
| A | EP-A-0 034 076 (BENDIX) <br> * Pages 1-7; page 9, ligne 24 - page 13, ligne 39 * | 1,2 | |

-----

DOMAINES TECHNIQUES RECHERCHES (Int Cl 4)

F 02 D
H 03 K
H 01 H

Le present rapport de recherche a ete etabli pour toutes les revendications

| Lieu de la recherche | Date d achevement de la recherche | Examinateur |
|---|---|---|
| LA HAYE | 25-06-1986 | LAPEYRONNIE P.J.F. |